Europäisches Patentamt

European Patent Office

Office européen des brevets

(11) Publication number: **0 232 127**
A2

# (12) EUROPEAN PATENT APPLICATION

(21) Application number: **87300770.2**

(22) Date of filing: **29.01.87**

(51) Int. Cl.⁴: **H 01 R 23/68**
**H 05 K 3/40**

(30) Priority: **31.01.86 JP 19899/86**

(43) Date of publication of application:
**12.08.87 Bulletin 87/33**

(84) Designated Contracting States: **DE FR GB IT**

(71) Applicant: **MINNESOTA MINING AND
MANUFACTURING COMPANY
3M Center, P.O. Box 33427
St. Paul, Minnesota 55133-3427 (US)**

(72) Inventor: **Hagiwara, Yoshichi c/o Minnesota Mining and
Manufacturing Company 2501 Hudson Road
P.O. Box 33427 St. Paul Minnesota 55133 (US)**

**Tanaka, Kenji c/o Minnesota Mining and
Manufacturing Company 2501 Hudson Road
P.O. Box 33427 St. Paul Minnesota 55133 (US)**

**Kimura, Naoya c/o Minnesota Mining and
Manufacturing Company 2501 Hudson Road
P.O. Box 33427 St. Paul Minnesota 55133 (US)**

**Emori, Kenji c/o Minnesota Mining and
Manufacturing Company 2501 Hudson Road
P.O. Box 33427 St. Paul Minnesota 55133 (US)**

**Kawamoto, Yoshitaka c/o Minnesota Mining and
Manufacturing Company 2501 Hudson Road
P.O. Box 33427 St. Paul Minnesota 55133 (US)**

(74) Representative: **Baillie, Iain Cameron et al
c/o Ladas & Parry Isartorplatz 5
D-8000 München 2 (DE)**

(54) Anisotropic electrically conductive film connector.

(57) The present invention provides an anisotropic electrically-conductive film connector comprising a conductive layer and an adhesive layer provided on at least one surface of the conductive layer. the conductive layer having a plurality of conductive elements electrically independent of each other. wherein, each of the conductive elements comprises a metal material having a substantially uniform thickness.

The present invention also provides an anisotropic electrically-conductive film connector which has a metal material which is uneven on its junction side surface.

## FIG. 1a

**Description**

ANISOTROPIC ELECTRICALLY CONDUCTIVE FILM CONNECTOR

Technical Field

The present invention relates to an anisotropic conductive film connector providing electric connection between opposing members, and particularly to an anisotropic film connector providing electric connection between a large scale integrated circuit (LSI) and a printed substrate, between an electric circuit and a lead wire, or the like.

Background Art

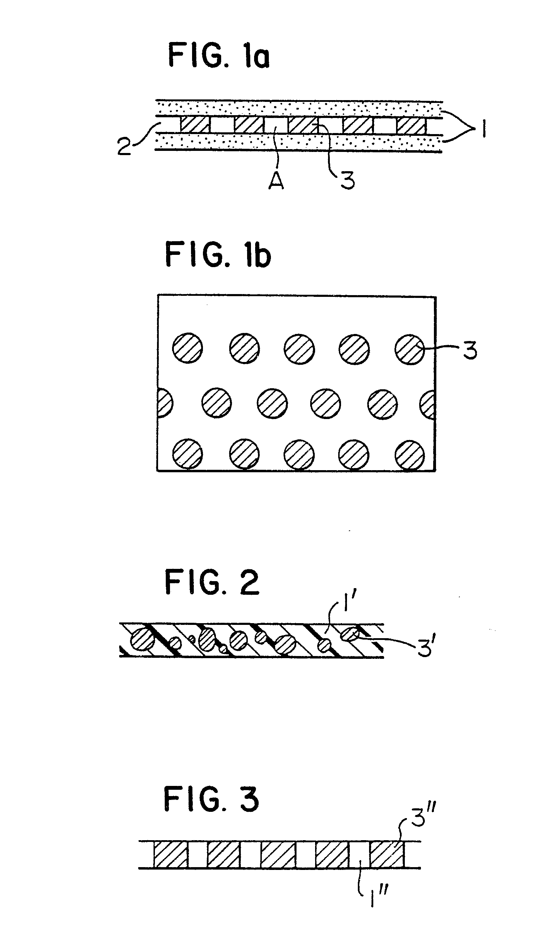

Conventionally, methods for the formation of electric connectors between opposing members have included, a soldering method; a conductive adhesive sheet as shown in Fig. 2, in which conductive particles are dispersed in an insulating resin to form a conductive layer having a thickness substantially equal to the grain size of the conductive particles (see, for example, Japanese Patent Unexamined Publication No. 21192/51); and a lamination-type connector as shown in Fig. 3, in which a conductive material composed of carbon particles or the like dispersed in an organic binder and an insulating layer mainly containing an organic binder are alternately stacked one on the other to form a lamination which is sliced to a desired thickness in use (see, for example, Japanese Patent Unexamined Publication No. 141807/57).

In soldering, however, it is necessary to pay close attention to the use a skilled technique so as to not short adjacent conductive materials to each other, resulting in poor workability.

Further, the use of a conductive adhesive sheet is shown in Fig. 2, in which the electrically conductive particles are dispersed in the insulating resin to thereby form the conductive layer having a thickness substantially equal to the grain size of the conductive particle, has the following disadvantages:

(a) When the conductive particles are dispersed in the insulating resin, it is difficult to perfectly avoid secondary aggregation of the conductive particles, so that it is difficult to obtain a plurality of conductive materials electrically independent of each other;

(b) Even if it is possible to disperse the conductive particles perfectly independently of each other, the tendency of each of the conductive particles to form a bridge between adjacent conduction paths increases as the interval between the adjacent conduction paths narrows, for example, 0.2 mm or less. Thus, it is difficult to prevent the adjacent conduction paths from being shorted;

(c) It is necessary to select conductive particles having a large grain size, for example, 5-100μm, to prevent the secondary aggregation of the conductive particles, so that the conductive particles easily precipitate even if they are dispersed in the insulating resin making it difficult to uniformly disperse the conductive particles;

(d) In the case where a conductive adhesive sheet is extruded with no solvent, the conductive particles can not smoothly pass through a cap split, so that is is difficult to obtain a sheet free from asperities.

As described above, it is difficult to obtain a highly reliable conductive sheet in which individual conductive particles are electrically independent of each other. Therefore, the use of the foregoing conductive adhesive sheet is limited to the case where each member connected to each other has adjacent conduction paths separated at a relatively wide interval.

Moreover, in the foregoing lamination-type connector, as shown in Fig. 3, arranged such that the conductive material formed by dispersing carbon particles or the like in an organic binder and the insulating layer are alternately stacked one on the other to form a lamination which is sliced to a desired thickness in use, the advantage is that a conductive layer having a uniform thickness can be obtained by slicing.

However, disadvantages include the time-consuming job of stacking the conductive material and the insulting layer one on the other to form a lamination and to slice the thus obtained lamination in use. Further, it is difficult to make the connection between the lamination type connector and opposing members compact because a mechanically connecting tool such as a clip or the like is required to be used for the connection. In addition, resistance against the current conduction is large because the electric conduction is obtained through the conductive particles such as carbon particles or the like, and therefore, the use of the lamination-type connector is limited to a liquid crystal display.

The present invention is intended to eliminate the foregoing disadvantages of the prior art, and to provide a conductive adhesive material having high reliability even on a connection between members in which paths are provided with a minute pitch, and having a small resistance against current conduction.

Disclosure of Invention

The present invention provides an anisotropic electrically-conductive film connector comprising a conductive layer and an adhesive layer provided on at least one surface of the conductive layer, the conductive layer having a plurality of conductive elements electrically independent of each other, wherein, each of the conductive elements comprises a metal material having a substantially uniform thickness.

The present invention also provides an anisotropic electrically-conductive film connector which has a metal material which is uneven on its junction side surface.

Brief Description of the Drawings

Figures 1(a) and (b) show the anisotropic electrically conductive film connector according to the present invention, in which the figures (a) and (b) are a cross section and a plan view thereof respectively;

Figure 2 is a cross section showing the conventional conductive adhesive tape;

Figure 3 is a cross section showing the conventional lamination type connector;

Figure 4 is a perspective view showing the case where the anisotropic conductive film connector according to the present invention is used for connecting a printed substrate and a flat cable to each other;

Figures 5 and 6 are cross sections showing other embodiments of the anisotropic conductive film connector according to the present invention.

Best Mode for Carrying out the Invention

Referring to Figures 1(a) and (b) the anisotropic conductive film connector according to the present invention, will be described hereunder. The present invention provides an anisotropic conductive film connector comprising a conductive layer 2 and an adhesive layer 1 provided on at least one surface of the conductive layer 2, the conductive layer 2 having a plurality of conductive elements 3 electrically independent of each other, in which each of the conductive elements 3 is comprised of by a conductive metal material having a substantially uniform thickness.

The conductive metal material having a substantially uniform thickness, according to the present invention, is used for obtaining electric conduction between opposing members. If the thickness is not substantially uniform, it is difficult to obtains highly reliable electrical connection. According to the present invention, it is possible to obtain a plurality of conductive elements 3, independent of each other and each having a substantially uniform thickness. This is obtained by, for example, spreading a resist material on a surface of a conductive metal thin film (which can be formed through plating, evaporating, sputtering, extrusion/extension, or the like), through a screen printing method, a photographic method, or the like. An etching process is performed to thereby remove unnecessary conductive metal thin film portions, and then the resist material is removed.

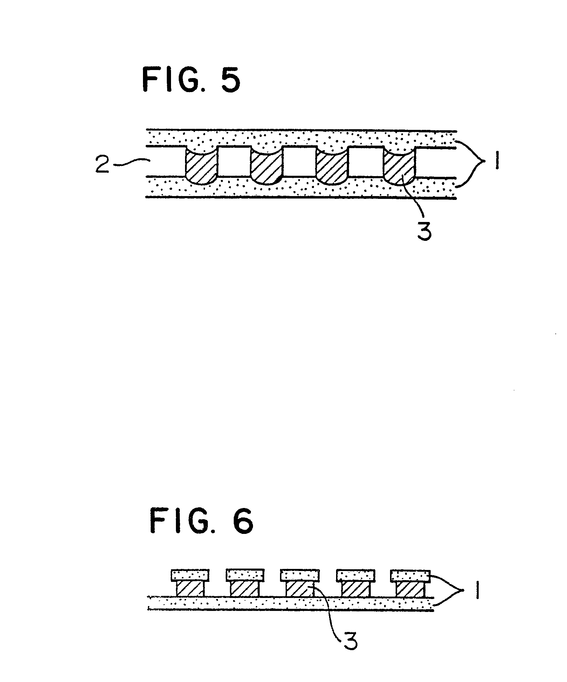

The conductive metal material may be curved so as to be raised at its opposite end portions slightly upward as shown in Fig. 5 or may be made uneven at its junction side surface, providing the advantage that the connection pressure between opposing members can be reduced and thus form a superior electrical connection.

The resistance of the conductive metal material is typically small as compared to conductive particles dispersed in an organic binder. Specifically, the conductive metal material may include generally used metals, such as copper, silver, nickel, iron or alloys thereof. Further, the surface of the conductive metal material may be plated with a noble metal which is corrosion resistant, for example, gold, silver, or the like. The dimensions of the conductive elements 3 can not be generally limited as the limit depends on the interval between adjacent conduction paths of members to be connected, the technical limit in an etching process, etc. However, if the conductive element 3 is too thick, it becomes difficult to perform fine etching processing and the cost is increased. If the conductive element 3 is selected to be too thin, it becomes difficult to make the adhesive layer thin corresponding to the thickness of the conductive material. Therefore, the thickness of the conductive elements 3 should be selected to fall within a range of, generally, 5-100 μm, preferably, 10-40 μm.

Further, if the diameter in section of each of the conductive elements 3 is too large, there is a risk of occurrence of short-circuit between adjacent conduction paths of the members to be connected, and there is a disadvantage that the connection pressure becomes large, and if it is too small, the working becomes difficult. Accordingly, the diameter is selected to fall within a range of, generally, 5-500 μm, preferably, 20-300 μm. Moreover, if the interval in plan between adjacent ones of the conductive elements 3 in each of the opposite members to be connected is too wide, there occurs a case where no conductive elements 3 exist corresponding the conduction path of the member to be connected, while if the interval is too narrow, there may be a possibility of contact or short circuit between the adjacent conductive elements 3. Therefore, the interval is selected to fall within a range of, generally, 5-1000 μm, preferably, 20-500 μm. Although the shape in plan of the conductive material is circular in the drawing (b) of Fig. 1, the shape may be modified into various shapes such as a polygon, an ellipse, and the like.

The adhesive agent for forming the adhesive layer of the present invention may be selected from various insulating adhesive agents such as a pressure-sensitive adhesive agent, a heat-sensitive adhesive agent, a photo-setting adhesive agent, an electron-beam setting adhesive agent, and the like, provided the adhesive agent can bond the conductive elements and the opposing member. Specifically, the adhesive agents may include various kinds of resins of a rubber group, of a polyester group, of a polyamide group, of a poly(meta)acrylic group, of an ethylene-vinyl acetate group, of a polyamide-phenol group, of a polyamide-epoxy group resin, of a terpon group, of an aliphatic group, and the like. These resins may contain a tackifier or non-conductive particles.

Further, if a material having an adhesive property is used as the foregoing resist material, not only the material can be used as it is as the adhesive layer 1 without being removed to thereby make it possible to omit the resist removing step, but also the adhesive layer on one surface is not formed into a continuous layer but stacked only on the conductive materials as shown in Fig. 6 so that conductive particles such as carbon particles or the like can be dispersed in the adhesive layer to thereby make it possible to more easily provide electric connection.

In the case where members to be connected are of an inorganic material and are different in kind from each other. for example, a plastic material and glass, respective adhesive agents selected to have highly adhesive properties to the foregoing materials of other respective members are provided on opposing surfaces of the conductive material.

The thickness of the adhesive layer according to the present invention is not particularly limited, however, if the adhesive layer is selected to be too thick, it is necessary to give a high pressure for obtaining electric conduction between the conductive materials and opposing member, so that the adhesive layer 1 moves considerably. the conductive elements 3 move correspondingly, and therefore there occurs a possibility of short-circuit between adjacent conductive elements 3.

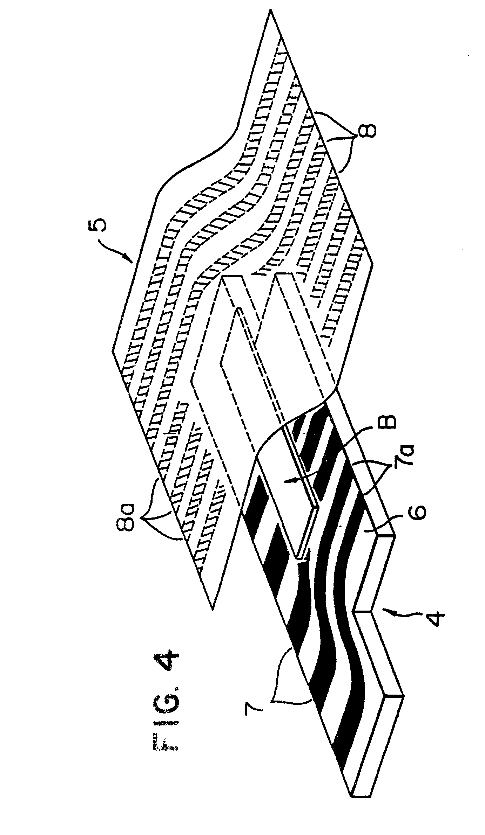

Next, referring to Fig. 4. description will be made as to how to use the anisotropic conductive film connector of the present invention in connecting opposing members to each other.

In Fig. 4, an end portion of a printed substrate 4 is made in the form of a connecting portion 6, and connecting terminals 7a of printed circuits 7 are formed at this connecting portion 6. On the other hand. connecting terminals 8a of conductors 8 are formed on a flat cable 5 corresponding to those connecting terminals 7a. After cut into a suitable shape, the anisotropic conductive film connector B according to the present invention is put on the connecting terminals 7a of the printed substrate 4, and the connecting terminals 8a of the flat cable 5 are put on the film connector B. Thereafter, the thus formed overlapped portion is pressed by suitable means such as heat welding. high-frequency welding, ultrasonic welding, or the like, to thereby electrically connect the connecting terminals 7a and 8a to each other through the anisotropic conductive film connector B.

Next, the anisotropic conductive film connector according to the present invention will be described further in detail with reference to following nonlimiting examples.

EXAMPLE 1

Copper foil having a thickness of 30 μm was prepared, and one of the opposite surfaces of this copper foil was coated with a polyester resin (VYLON 20SS made by Toyobo Co. Ltd.) having a dry thickness of about 15 μm. The other surface of the copper foil was coated with a positive-type photo resist material (OFPR PR 3FH315 made by Tokyo Kogyo Co., Ltd.) with a dry thickness of about 3 μm, ad then exposed to light for 3 seconds by using a high-pressure mercury lamp (JP-2000 made by Ohku Seisakusho) through a dot positive film (Sakurai Co., Ltd., Startaint 150 lines/inch, 20%). The thus processed foil was then dipped in 1% NaOH aqueous solution at 25°C for 1 minute, washed by water, dried, and then subject to spray etching with 42% ferric chloride aqueous solution to 40°C for 70 seconds. After washed by water and dried, the etched foil was dipped in 3% NaOH aqueous solution at 40°C for 1 minute to thereby flake the resist material. A separately prepared polypropylene film onto which a polyester resin (VYLON 20SS, with a dry thickness of about 15 μm) had been applied was laminated on the resist-flaked surface to thereby obtain the anisotropic conductive film connector according to the present invention. Table 1 shows the connection pressure between opposing members in the case where various dot positive films (150 lines/inch) of different article numbers were used and the diameter in plan of the conductive material was changed. As the opposing members, an epoxy/glass printed circuit substrate and a polyamide printed circuit substrate were used. Each of the printed circuit substrates has 10 current conduction paths arranged with a pitch of 0.4 mm, each current conduction path having a width of 0.2 mm and a thickness of 35 μm and being plated with gold. The overlapped distance between the members to be connected was set to 5 mm, and the members were connected to each other through the connector which was set at 170°C. Each of the connection pressure in the Table 1 shows the value measured when the electric resistance value across the conduction paths became 0.1 or less. In any cases, the mechanical adhesive strength was sufficiently large and short-circuit between adjacent conduction paths was not detected.

## Table I

| Positive film used (%) | Plane diameter of conductive material (μm) | Connection pressure (Kg/cm²) |
|---|---|---|
| 60 | 90 | 10.0 |
| 70 | 50 | 2.5 |
| 80 | 20 | 1.5 |

EXAMPLE 2

Anisotropic conductive film connectors provided with conductive materials having plane diameters different from each other, according to the present invention, were obtained by using newly formed dot position films in the same manner as in the Example 1. The same opposing members and the same connecting conditions as those in the Example 1 were employed except that the pitch of the current conduction paths of the opposing members and the width of the respective current conduction path were changed to be 1 mm and 0.5 mm respectively. The results of measurement are shown in Table 2.

Comparative Example 1

As a comparative example of a conductive sheet was formed in such a manner as follows: 4.5 g of silver particles (produced by CERAC, Inc., U.S.A.; -200, +300 meshes) were added to a 30 g of polyester resin (VYLON 20SS 30% solution), the mixture was rapidly applied to a polypropylene film to a thickness equal to the diameter of the silver particles by using a knife coater while sufficiently stirring the mixture so as to prevent the silver particles from being precipitated. Although the thus obtained conductive sheet was unsatisfactory because the silver particles were not uniformly dispersed, the conductive sheet was evaluated by using a portion thereof of a relatively good state, in the same manner as in the foregoing Examples of the invention.

Although in all the foregoing Examples of the invention the mechanical adhesive strength was sufficiently large and no short circuit between adjacent current conduction paths was not recognized, in the Comparative Example, defection in electric conduction and short-circuit due to defection in dispersion of the silver particles were caused.

## Table 2

|  | Positive film used (%) | Plane diameter of conductive material ($\mu$m) | Connection pressure (Kg/cm$^2$) |
|---|---|---|---|
| Example 2 | 125 | 100 | 10 |
|  | 60 | 200 | 18 |
|  | 50 | 300 | 30 |
| Comparative Example A | – | – | 70 |

EXAMPLE 3

A stainless steel screen used for screen printing was prepared by using a dot positive film (Startaint 100 lines/inch, 90% made by Sakurai Co., Ltd). A polyester resin (VYLON 20SS made by Toyobo Co., Ltd.) was applied onto one surface of copper foil having a thickness of 30 $\mu$m. A polyester resin was applied to the whole of the other surface of the copper foil to a thickness of 15 $\mu$m and dried. The thus processed copper foil was etched in the same manner as in the Example 1 to thereby obtain the anisotropic conductive film connector according to the present invention. The mean value of the diameters of the conductive particles in the thus obtained film connector was 50 $\mu$m.

EXAMPLE 4

Copper foil having opposite surfaces plated with silver to a thickness of about 1 $\mu$m was prepared, and a polyester resin (VYLON 20SS made by Toyobo Co., Ltd.) was applied onto a surface of the foil to a thickness of about 10 $\mu$m. A positive-type photo resist ( OFPR RF3FH315 made in Tokyo Ohku Kogyo Co. Ltd.) was applied onto the other surface of the foil, exposed to light through a positive film (Startaint 150 lines inch, 70% made by Sakurai Co., Ltd.), and then developed in the same manner as in the Example 1. After development, the plated silver layer on the surface was etched by using the following solution to thereby be removed.
930 (made by Japan Metal Finishing Co., Ltd) 10 weight percent
35% hydrogen peroxide solution 50 weight percent
Water 40 weight percent

Then, after the copper foil had been etched in the same manner as in the Example 1, the silver layer on the other surface was etched to be removed by the above-mentioned solution. Next, the remaining resist was removed by 3% NaOH aqueous solution. Finally, a different polyester resin (BYLON 30SS made by Toyobo Co., Ltd.) was laminated on the metal surface to thereby obtain an anisotropic conductive film connector according to the present invention. The thus obtained anisotropic conductive film connector was used for connecting a polyester flexible printed substrate and a glass/epoxy printed substrate to each other, resulting in good current conduction and sufficient mechanical adhesive strength.

EXAMPLE 5

Several kinds of resins shown in Fig. 3 were applied onto a polyester film or a polypropylene film and dried to thereby obtain an adhesive film having a thickness of 15 μm. After nickel foil of 10 μm thick had been laminated on the thus obtained film, resist application, drying, exposure to light, development, etching and resist flaking were effected in the same manner as in the Example 1 to thereby obtain an anisotropic conductive film connector. In the Example 5, a dot positive film of 200 lines/inch with an 80% space factor was used. The second layer of adhesive agent was not laminated.

The thus obtained anisotropic conductive film connector was used for the connection between a polyester base FPC (Cu/PET = 30/50 μm, 0.2 mm width, 0.3 mm conductor pitch, conductors being plated by soldering) and conductive glass (indium-tin oxide). The initial resistance values and the resistance values after time elapsed (wet-heating cycle test, -20°C to 70°C, 90% RH; -20°C for 2 hours, 70°C, 90% RH for 2 hours, shift 2 hours) are reported in Table 3. In this case, the connection was effected at the connector temperature of 185°C, at the pressure of 20 Kg/cm², for 15 seconds. In every case, characteristics having no problem in practical use were obtained.

## Table 3

| Adhesive agent | Initial resistance Ω | Resistance after time elapsed (250 h) Ω |
|---|---|---|
| Phenoxy resin (PKHH: Union Carbide Corp.) | 45 | 145 |
| Rubber group adhesive (EC-776: Sumitomo 3M Ltd.) | 40 | 128 |
| Polyester adhesive (K-1294: Toray Industry Inc. | 50 | 160 |

EXAMPLE 6

A phenoxy resin (PKHH made by Union Carbide Corp.) was applied onto a polyester film to thereby obtain a film having a thickness of 15 μm. The thus obtained film was laminated on nickel foil having a thickness of 10μm, and an embossing roll provided with silk mesh patterns of 200 meshes was rolled on the nickel foil surface to thereby make the surface finely uneven.

A positive-type photo resist (PM5R 800 H315 made by Tokyo Ohku Kogyo Co., Ltd.) was applied to the whole of the embossed surface by using a bar coater and dried. The whole surface was exposed to light by using a high-pressure mercury lamp (JP-2000 made by Ohku Seisakusho) for 10 seconds, developed by using a developer (PMER developer P-1S made by Tokyo Ohku Kogyo Co., Ltd.) and etched in the same manner as in the Example 1. Thereafter, the remaining resist was removed by using a 3% NaOH aqueous solution to thereby obtain an anisotropic conductive film connector. The mean value of diameters of conductive particles in the thus obtained anisotropic conductive film connector was 50 μm. By using the thus obtained film connector (using phenoxy resin) and the film connector obtained in the Example 5, the same evaluation as is the Example 5 was effected. The results are reported in the following Table 4. The number of evaluated terminals was 20 for every condition.

## Table 4

| Anisotropic film con- nector used | Connection Pressure (Kg/cm²) | Initial | | After time elapsed (250 hours) | |
|---|---|---|---|---|---|
| | | Resistance (Ω) | Number of open terminals | Resistance (Ω) | Number of open terminals |
| Example 6 | 10 | 40 | 0 | 140 | 0 |
| | 20 | 30 | 0 | 95 | 0 |
| Example 5 | 10 | 150 | 0 | – | 3 |
| | 20 | 45 | 0 | 145 | 0 |

As described above, in the anisotropic conductive film connector according to the present invention, a material having a substantially uniform thickness is used as the conductive material, so that plane connection can be obtained in the connection between the film connected and each be obtained in the connection between the film connected and each of the opposite members to be connected unlike the case where conductive particles having diameters different from each other are used, whereby high reliable current conduction can be obtained with a low connecting pressure.

Further, because the conductive material according to the present invention can be formed by etching-processing a thin metal film and because the conductive material can be subject to accurate processing, the opposing members can be surely connected without generating short-circuit between adjacent current conduction paths on each of the opposing members even where the current conduction paths are disposed with a fine pitch on each of the opposing members. Further, the conductive material can be easily changed in shape, in size, and in density by changing only the positive film. Particularly, it is possible to obtain highly reliable current conduction and a high heat conduction property by increasing the density of the conductive material even is a lower connection pressure is used.

Because the conductive material employs a thin metal film, it is not necessary to consider uniform dispersion of conductive particles as well as property of current conduction in the inside of the conductive material in the case where the conductive material is formed by dispersing conductive particles, and the resistance against current conduction is small. Accordingly, the anisotropic conductive film connector according to the present invention can be used widely.

Further, if the material of the adhesive layer is property selected when opposing members are connected to each other through the anisotropic conductive film connector according to the present invention, it is possible to obtain current conduction only at a portion which has been subject to connection processing while the remainder portion is kept in an insulated condition.

**Claims**

1. An anisotropic electrically-conductive film connector comprising a conductive layer and an adhesive layer provided on at least one surface of said conductive layer, said conductive layer having a plurality of conductive elements electrically independent of each other, wherein each of said conductive elements comprises a metal material having a substantially uniform thickness.

2. The anisotropic electrically-conductive film connector of Claim 1, wherein said metal material is uneven on its junction side surface.

# FIG. 1a

# FIG. 1b

# FIG. 2

# FIG. 3

FIG. 4

## FIG. 5

## FIG. 6